# FASCICULE DE BREVET EUROPEEN

(11) **EP 1 736 784 B1**
(45) Date de publication et mention de la délivrance du brevet: **14.11.2007**
(21) Numéro de dépôt: 06354018.1
(22) Date de dépôt: 02.06.2006
(51) Int. Cl.: G01R 15/18, H02H 3/347, H01H 83/14

(54) **Dispositif de mesure de courant différentiel, module de déclenchement et dispositif de coupure**
Gerät zur Fehlerstrommessung, Auslösemodul und Schaltvorrichtung
Differential current measuring apparatus, tripping device and switchgear

(30) Priorité: 24.06.2005 FR 0506438
(43) Date de publication de la demande: 27.12.2006
(73) Titulaire: SCHNEIDER ELECTRIC INDUSTRIES SAS, 92500 Rueil-Malmaison (FR)
(72) Inventeur: Mas, Patrick, Schneider Electric Industries SAS, 38050 Grenoble Cedex 09 (FR); Buffat, S., Schneider Electric Industries SAS, 38050 Grenoble Cedex 09 (FR)
(74) Mandataire: Tripodi, Paul

(56) Documents cités:
- EP-A- 0 959 484
- EP-A- 1 475 874

## Description

### DOMAINE TECHNIQUE DE L'INVENTION

L'invention est relative à un dispositif de mesure de courant différentiel destiné à la mesure de courant différentiel dans aux moins deux lignes de courant. Ledit dispositif comporte un premier circuit magnétique destiné à entourer les lignes de courant, formant un circuit primaire d'un transformateur et comporte un premier enroulement secondaire enroulé autour dudit circuit magnétique et formant le circuit secondaire du transformateur. Un blindage métallique entoure le premier enroulement secondaire et le circuit magnétique.

### ETAT DE LA TECHNIQUE

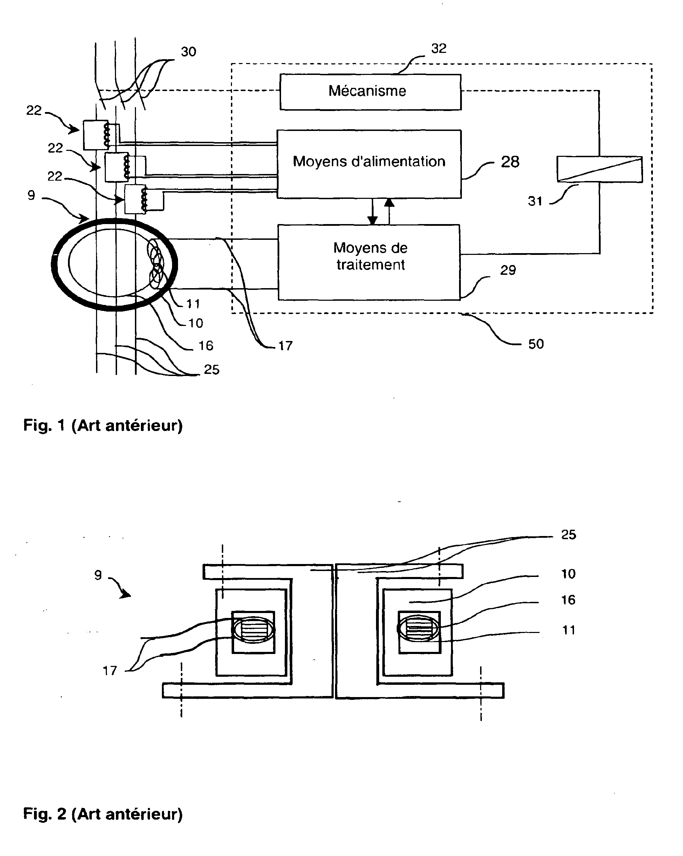

Pour détecter la présence de courants différentiels circulant dans des lignes électriques de courant ou des conducteurs électriques 25, il est largement répandu d'utiliser des capteurs différentiels comportant un premier enroulement secondaire 11 enroulé autour d'un noyau magnétique 16. Comme représenté sur les figures 1 et 2, ledit noyau, notamment une forme circulaire ou rectangulaire, entoure les lignes électriques de courant ou les conducteurs électriques 25. Les lignes électriques de courant ou les conducteurs électriques seront appelés par la suite lignes de courant.

Le premier enroulement secondaire 11 enroulé sur le noyau 16 forme un enroulement secondaire d'un transformateur où les lignes de courant 25, forment le circuit primaire. Ledit enroulement secondaire fournit un si6gnal de mesure. En effet, la tension fournie aux bornes de l'enroulement secondaire est directement proportionnelle à l'intensité de la somme des courants électriques circulant dans les lignes de courant 25. Le premier enroulement secondaire 11 du capteur différentiel est destiné à être relié à des moyens de traitement 29 d'un dispositif de coupure 50. Ces moyens de traitement 29 analysent le signal reçu et peuvent notamment commander l'ouverture de contacts 30 placés sur les lignes électriques de courant 25. L'ouverture des contacts 30 est réalisée par un mécanisme de commande 32 via un relais 31.

Compte tenu de la forte sensibilité de ce type de capteurs différentiels 9 destinés à mesurer de faibles courants électriques, le premier enroulement secondaire 11 est généralement placé dans un blindage 10.

Le blindage 10 du capteur différentiel permet de réduire l'influence des perturbations extérieures qui peuvent dans certains cas introduire des erreurs de mesure du courant différentiel et provoquer des déclenchements intempestifs en cas de surcharge.

Comme décrit dans les documents EP0959484, W09119305, l'utilisation d'un blindage 10 placé autour d'un capteur différentiel est largement répandue. Le blindage 10 peut être constitué de plusieurs parties, notamment d'un blindage extérieur, d'un blindage intérieur et d'au moins un blindage latéral.

La mesure du courant différentiel est généralement faite de façon concomitante avec la mesure des courants électriques circulant respectivement dans les lignes de courant 25. Les courants électriques circulant respectivement dans les lignes de courant 25 sont appelés par la suite les courants principaux.

Un capteur différentiel 9 destiné à mesurer des courants de faible intensité, ne peut pas fournir d'informations relatives aux courants principaux. En effet, un capteur différentiel est rapidement saturé par la présence de courant électrique de forte intensité, notamment les courants de court-circuit.

La mesure de courants électriques est ainsi généralement faite par des capteurs de courant 22 placés de manière indépendante sur les lignes de courant 25. Comme représenté sur la figure 1, les capteurs de courant 22 sont reliés de manière traditionnelle aux moyens de traitement 29 d'un dispositif de coupure 50. Lesdits capteurs ayant pour but de mesurer les courants électriques circulant dans les lignes de courant 25, les informations envoyées aux moyens de traitement 29 permettent notamment d'assurer la protection de la ligne de courant sur laquelle est positionné ledit capteur.

Ces capteurs de courant 22 peuvent être aussi connectés à des moyens d'alimentation 28 afin d'assurer l'alimentation des moyens de traitement 29. Ainsi, grâce aux capteurs de courant 22, l'alimentation électrique des moyens de traitement 29 associés au capteur différentiel 9 est faite sans alimentation électrique auxiliaire.

Le positionnement de l'ensemble des capteurs de courant 22, 9 dans un dispositif de coupure 50 peut devenir critique lorsque l'espace disponible à l'intérieur dudit dispositif de coupure est réduit. Comme cela est représenté sur la figure 1, ceci est particulièrement vérifié lorsque le dispositif de coupure 50 est tétrapolaire ou tripolaire et que chacune des lignes de courant 25 comporte un capteur de courant 22 et qu'un capteur différentiel 9 entoure les lignes de courant 25.

Certaines solutions notamment décrites dans le document EP1045500 se contentent d'utiliser uniquement deux capteurs de courant au lieu de trois. Un traitement électronique permet de reconstituer, à partir des informations de deux capteurs de courant, l'information manquante de la troisième ligne de courant. Dans cette dernière architecture, la protection n'est cependant pas assurée si un court-circuit monophasé survient sur la ligne de courant dépourvue de capteur de courant. Le capteur différentiel destiné généralement à mesurer de faible courant de quelques dizaines de milliampères est alors saturé du fait de la présence de courant de court-circuit et ne peut fournir une information.

### EXPOSE DE L'INVENTION

L'invention vise donc à remédier aux inconvénients de l'état de la technique, de manière à proposer un dispositif de mesure de courant électrique différentiel ayant une plage de mesure large permettant à la fois de mesurer de faibles courants différentiels et de forts courants de court-circuit.

Le dispositif de mesure selon l'invention comprend au moins un second enroulement secondaire entourant au moins une partie du blindage métallique et constituant un second circuit magnétique d'au moins un second capteur de courant destiné à fournir un signal électrique représentatif d'un courant circulant dans au moins une ligne de courant.

De préférence, le blindage métallique est constitué d'un blindage extérieur, d'un blindage intérieur et d'au moins un blindage latéral.

Avantageusement, le blindage métallique comporte deux blindages latéraux.

Dans un mode de réalisation particulier, au moins un second enroulement secondaire entoure au moins une partie du blindage extérieur, au moins une partie du blindage intérieur et au moins une partie des blindages latéraux. Lesdits blindages entourés par ledit au moins un second enroulement secondaire forment le circuit magnétique d'au moins un second capteur de courant, chaque blindage entourant les lignes de courant.

Avantageusement, un second enroulement secondaire entoure totalement le blindage métallique.

Avantageusement, au moins un second enroulement secondaire entoure au moins une partie d'un des blindages latéraux.

Avantageusement, au moins un second enroulement secondaire entoure un des deux blindages latéraux.

Selon un mode de développement de l'invention, au moins un second enroulement secondaire entoure au moins une partie d'un premier blindage latéral, et au moins un second bobinage secondaire entoure au moins une partie du second blindage latéral. Lesdits blindages entourés forment les circuits magnétiques d'au moins deux seconds capteurs de courant.

Dans un mode de réalisation particulier, au moins un des blindages entouré par un second enroulement secondaire comporte au moins un entrefer.

Module de déclenchement destiné à se connecter à un dispositif de coupure et comprenant N lignes de courant comprend un dispositif de mesure de courant différentiel tel que défini ci-dessus. Le dispositif de mesure est positionné autour des lignes de courant. Le second capteur de courant du dispositif de mesure de courant différentiel est destiné à être relié à des moyens d'alimentation et/ou des moyens de traitement d'un dispositif de coupure, le premier enroulement secondaire du dispositif de mesure de courant différentiel étant destiné à être relié à des moyens de traitement dudit dispositif de coupure.

Avantageusement, au moins N-1 lignes de courant possèdent respectivement un capteur de courant mixte comportant un premier bobinage enroulé sur un circuit magnétique et destiné à être relié aux moyens d'alimentation d'un dispositif de coupure. Le capteur de courant mixte comprend aussi un second bobinage enroulé sur un circuit amagnétique et destiné à être relié aux moyens de traitement d'un dispositif de coupure.

Dispositif de coupure destiné à la protection d'au moins N lignes de courant, comprend des moyens d'alimentation, des moyens de traitement, un mécanisme d'ouverture de contacts électriques et comporte un module de déclenchement tel que défini ci-dessus. Les moyens de traitement du dispositif de coupure sont connectés au dispositif de mesure de courant différentiel dudit module de déclenchement.

Avantageusement, les moyens d'alimentations sont reliés aux capteurs de courant mixtes du module de déclenchement via les bobinages et sont reliés à au moins un second enroulement secondaire du dispositif de mesure de courant différentiel.

Avantageusement, les moyens de traitement sont reliés aux capteurs courant mixtes du module de déclenchement via les bobinages et sont reliés au premier enroulement secondaire du dispositif de mesure de courant différentiel.

### BREVE DESCRIPTION DES FIGURES

D'autres avantages et caractéristiques ressortiront plus clairement de la description qui va suivre d'un mode particulier de réalisation de l'invention, donné à titre d'exemple non limitatif, et représenté aux dessins annexés sur lesquels :
- la figure 1 représente un schéma bloc d'un dispositif de coupure de type connu intégrant des capteurs de courant et un capteur différentiel ;
- la figure 2 représente une vue schématique en coupe d'un capteur différentiel blindé de type connu ;
- les figures 3 et 4 représentent un dispositif de mesure de courant différentiel selon un mode de réalisation de l'invention ;
- les figures 5 à 10 représentent des variantes de réalisation du dispositif de mesure de courant différentiel selon les figures 3 et 4 ;
- la figure 11 représente un schéma bloc d'un dispositif de coupure comportant un module de déclenchement selon un mode de réalisation de l'invention ;
- la figure 12 représente un schéma bloc d'un mode particulier de réalisation des moyens de traitement du dispositif de coupure selon la figure 11.

### DESCRIPTION DETAILLEE D'UN MODE DE REALISATION

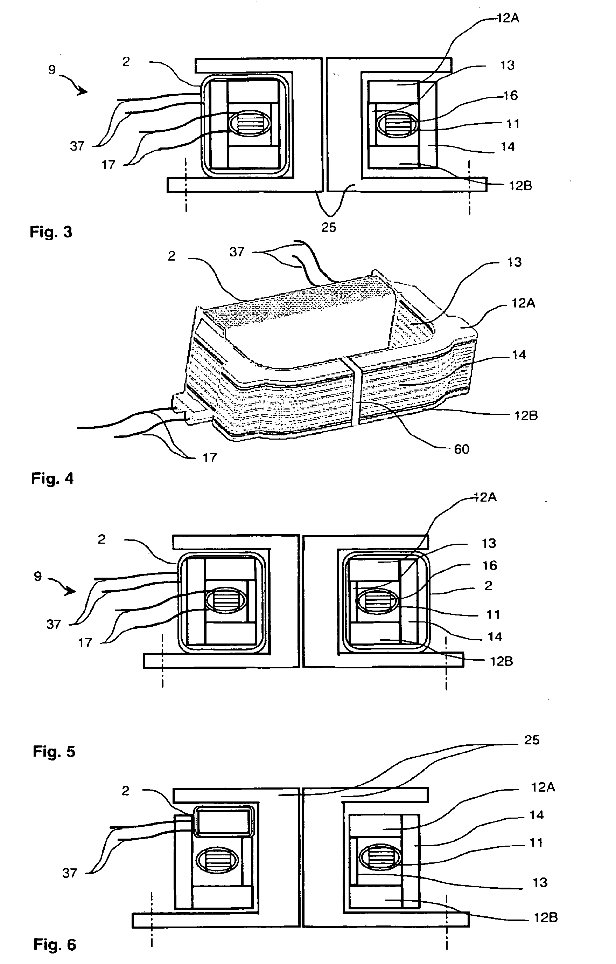

Selon le mode de réalisation préférentiel de l'invention représenté sur les figures 3 et 4, le dispositif de mesure de courant différentiel 9 comporte un noyau magnétique 16 ayant contour rectangulaire sensiblement fermé. Ledit noyau réalisé à partir de matériau magnétique hautement perméable en alliage cristallin ou nanocristallin. Le noyau magnétique 16 est de section rectangulaire et peut être réalisé à partir d'un ruban enroulé ou bien de tôles empilées. Pour optimiser la sensibilité du dispositif de mesure de courant différentiel 9, le noyau 16 ne comporte pas d'entrefer. Ledit noyau est destiné à venir entourer lignes de courant 25.

Le noyau magnétique 16 est entouré d'un premier enroulement secondaire 11 destiné à mesurer un courant différentiel pouvant circuler dans les lignes de courant 25. Le premier enroulement secondaire 11 est réparti sur tout le périmètre du noyau magnétique 16.

Ce premier enroulement secondaire 11 forme ainsi l'enroulement secondaire d'un transformateur de courant. Le circuit primaire est constitué par des lignes de courant 25. Le premier enroulement secondaire 11 est destiné à être relié aux moyens de traitement d'un dispositif de coupure 50 via des fils de connexion 17.

Un blindage 10 métallique est utilisé pour limiter l'influence des perturbations extérieures sur la mesure de courant différentiel. Ce blindage 10 est constitué d'un blindage extérieur 14, d'un blindage intérieur 13 et d'au moins un blindage latéral 12. Dans le mode de réalisation décrit, afin de limiter au mieux l'influence des perturbations extérieures, deux blindages latéraux 12A, 12B sont utilisés. De préférence, chaque partie 12, 13 et 14 du blindage 10 entoure les lignes de courant 25. Chaque partie 12, 13 et 14 du blindage 10 peut être réalisée en ruban enroulé ou en tôles empilées.

Les blindages sont constitués de matériau magnétique d'induction de saturation élevée et de préférence de perméabilité élevée. Le choix d'un matériau d'induction de saturation élevée permet au blindage de ne pas saturer en présence de forts courants principaux.

Au moins un second enroulement secondaire 2 entoure une partie du blindage 10. Selon un mode de réalisation de l'invention représenté sur les figures 3 et 4, un second enroulement secondaire 2 entoure au moins une partie du blindage extérieur 14, au moins une partie du blindage intérieur 13 et au moins une partie des blindages latéraux 12A, 12B. Chacun des blindages 13, 14, 12A, 12B entoure les lignes de courant 25.

Lesdits blindages entourés par le second enroulement secondaire 2 forment le circuit magnétique d'un second capteur de courant. Le second capteur de courant est destiné à être relié aux moyens de traitement 29 d'un dispositif de coupure 50 via des fils de connexion 37.

Suivant le type d'application, ce second capteur de courant peut être relié et/ou aux moyens d'alimentation 28 du dit dispositif de coupure.

Ce second capteur peut être destiné à faire de la mesure de courant différentiel de forte intensité, pour étendre la dynamique de mesure du capteur différentiel. Selon le mode de réalisation décrit, le matériau utilisé pour la réalisation du blindage est constitué d'un alliage de fer (Fe) et de silicium (Si). Cet alliage (FeSi) ne présente pas une perméabilité suffisante pour mesurer de faibles courants différentiels. Ainsi, lorsque le blindage ne comporte pas d'entrefer, on peut en effet mesurer des courants différentiels moyens et forts c'est à dire de 300mA et au-delà.

En outre, ce capteur peut aussi réaliser des mesures de courants principaux de forte intensité, notamment sur une ligne de courant dépourvue d'un capteur de courant mixte 22. Il est alors indispensable de créer un entrefer 60 sur au moins une partie du blindage 10 afin que dernier ne soit pas saturé au passage du courant.

Selon un second mode de réalisation de l'invention tel que représenté sur la figure 5, au moins un second enroulement secondaire 2 entoure totalement le blindage métallique 10.

Selon une variante de réalisation de l'invention représentée sur la figure 6, au moins un second enroulement secondaire 2 peut entourer au moins une partie d'un des deux blindages latéraux 12A ou 12B. La partie du blindage 10 entourée par le bobinage secondaire 2 entoure les lignes de courant 25.

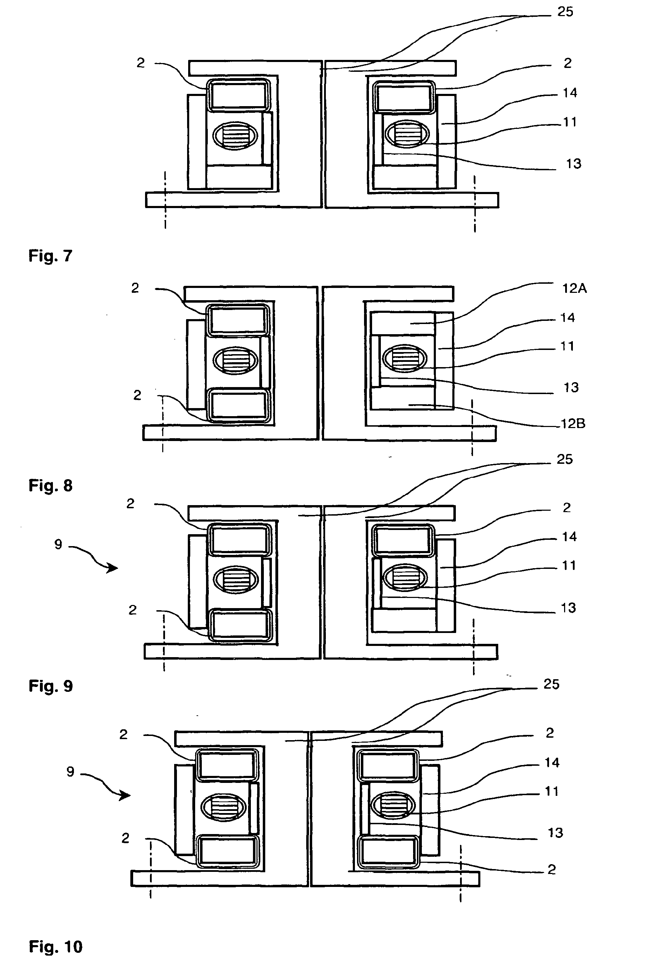

Selon une autre variante de réalisation de l'invention représentée sur la figure 7, un second enroulement secondaire électrique 2 peut entourer entièrement un des blindages latéraux 12A, 12B.

Selon une autre variante de réalisation de l'invention représentée sur les figures 8 à 10, un second enroulement secondaire électrique 2a peut entourer au moins une partie d'un premier blindage latéral 12A, et un second enroulement secondaire électrique 2b peut entourer au moins une partie du second blindage latéral 12B. Lesdits blindages entourés par les seconds enroulements secondaires électriques 2a, 2b forment les circuits magnétiques d'au moins deux seconds capteurs de courant.

Selon une autre variante de réalisation, le noyau magnétique 16 peut avoir contour circulaire, ovale ou elliptique.

Le dispositif de mesure de courant différentiel 9 selon les différents modes de réalisation de l'invention, est particulièrement destiné à être combiné à un module de déclenchement 40 destiné à envoyer des ordres à un dispositif de coupure 50. Le module de déclenchement 40 est destiné à se connecter à un dispositif de coupure 50 destiné à se connecter au moins N lignes de courant 25. Le dispositif de mesure de courant différentiel 9 selon les modes de réalisation de l'invention est positionné autour des N lignes de courant 25.

En outre, le module de déclenchement 40 comporte de préférence au moins un capteur de courant mixte 26 placé sur au moins une ligne de courant 25. Lesdits capteurs 26 sont des capteurs magnétiques mixtes comportant un premier bobinage 35 enroulé sur un circuit magnétique 33 et destiné à être relié aux moyens d'alimentation 28 d'un dispositif de coupure 50. Les capteurs de courant mixtes 26 comportent un second bobinage 34 destiné à être relié aux moyens de traitement 29 d'un dispositif de coupure 50. Les seconds bobinages 34 sont enroulés sur un support en matériau amagnétique placé autour d'une ligne de courant 25 dans lequel circule le courant à mesurer. Le second bobinage 34 forme un enroulement secondaire d'un transformateur de courant où ladite ligne de courant 25 constitue un enroulement primaire. L'enroulement secondaire fournit un signal de mesure directement proportionnelle à l'intensité du courant électrique circulant dans la ligne de courant 25. L'absence de noyau magnétique risquant d'être saturé, permet une large dynamique de mesure. L'ensemble 34, 25 forme un capteur de type Rogoswki destiné à la protection en cas de court-circuit monophasé survenant sur la ligne de courant pourvue dudit capteur. L'ensemble des caractéristiques des capteurs de courant mixtes 26 est décrit dans la demande de brevet FR de la demanderesse enregistrée sous le numéro 0405199. La description de ladite demande est sur ces points incorporée ici par référence.

Dans l'exemple de réalisation, N-1 lignes de courant 25 possèdent respectivement un capteur de courant mixte 26.

Par ailleurs, le module déclenchement 40 selon l'invention peut être intégré dans un dispositif de coupure électrique 50 tel qu'un disjoncteur.

Le disjoncteur 50 est monté sur des lignes courant électrique 25. Les premiers bobinages 35 des capteurs de courant mixtes 26 du module de déclenchement 40 sont alors connectés aux moyens d'alimentation 28 du dispositif de coupure 50. Les seconds bobinages 34 sont reliés aux moyens de traitement 29. Les moyens de traitement 29 sont eux-mêmes alimentés par les moyens d'alimentation 28.

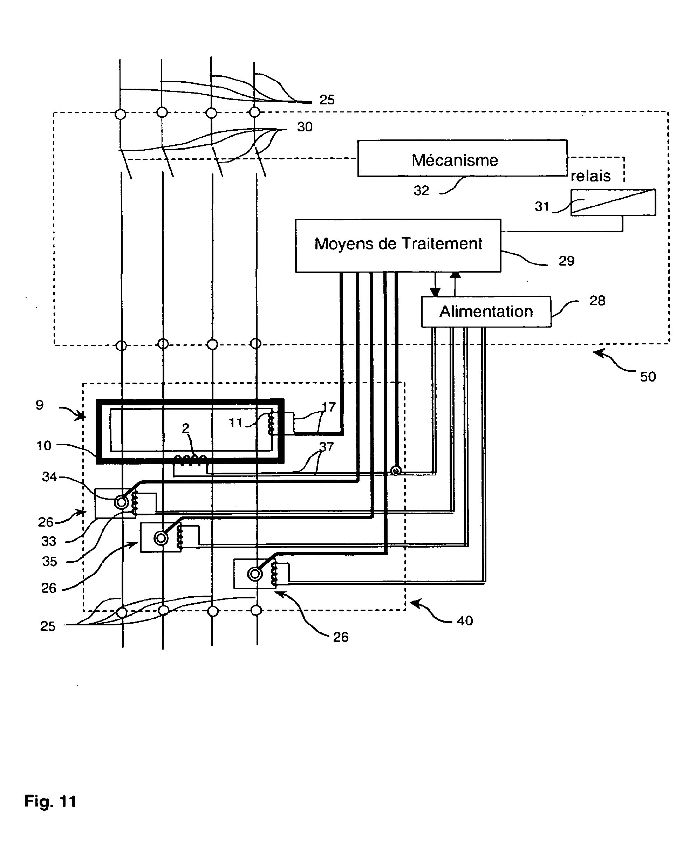

Comme cela est représenté sur la figure 11, N-1 lignes de courant 25 comportent respectivement un capteur de courant mixte 26.

Le fonctionnement du dispositif de coupure 50 est le suivant. Si un courant différentiel est détecté par le capteur différentiel 9, les moyens de traitement 29 ayant reçu cette information, envoient un ordre de commande d'ouverture des contacts 30 au mécanisme d'ouverture 32 via le relais 31. Les moyens de traitement 29 sont alimentés par les moyens d'alimentation 28 via les bobinages 35 des N-1 capteurs de courant mixtes 22.

Si un défaut de court-circuit est détecté sur une des lignes de courant 25 comportant un capteur de courant mixte 26, les moyens de traitement 29 envoient un ordre de commande d'ouverture des contacts 30 au mécanisme d'ouverture 32 via le relais 31.

Si un défaut de court-circuit apparaît sur la ligne de courant 25 qui ne comporte pas de capteur de courant mixte 26, l'information de court-circuit est tout de même reçue et analysée par les moyens de traitements 29 via le second capteur du capteur différentiel 9. Les moyens de traitement 29 envoient alors un ordre de commande d'ouverture des contacts 30 au mécanisme d'ouverture 32 via le relais 31.

Ainsi, dans cette nouvelle architecture, grâce à la présence du second capteur du capteur différentiel 9, la protection de l'installation est tout de même assurée si un court-circuit monophasé survient sur la ligne de courant dépourvue de capteur de courant mixte 26. En outre, l'ordre d'ouverture des contacts 30 est envoyé bien que le capteur différentiel 9 soit saturé du fait de la présence de courant de court-circuit.

Selon une variante de réalisation, les moyens de traitement 29 permettent de reconstituer, à partir des signaux de mesure Isn, Is1, Is3 des deux ou trois capteurs de courant mixte 26, la valeur manquante du courant I2 circulant dans la dernière ligne de courant dépourvu de capteur de courant 26.

Les signaux Isn, Is1, Is3 sont représentatifs des courants électriques primaires Ipn, Ip1, Ip3 circulant dans les lignes de courant 25 à protéger. Selon ce mode particulier de réalisation de l'invention, le signal Isn est représentatif d'un courant primaire de neutre Ipn. En outre, les signaux Is1 et Is3 sont représentatifs des courants primaires Ip1, Ip3 de deux phases.

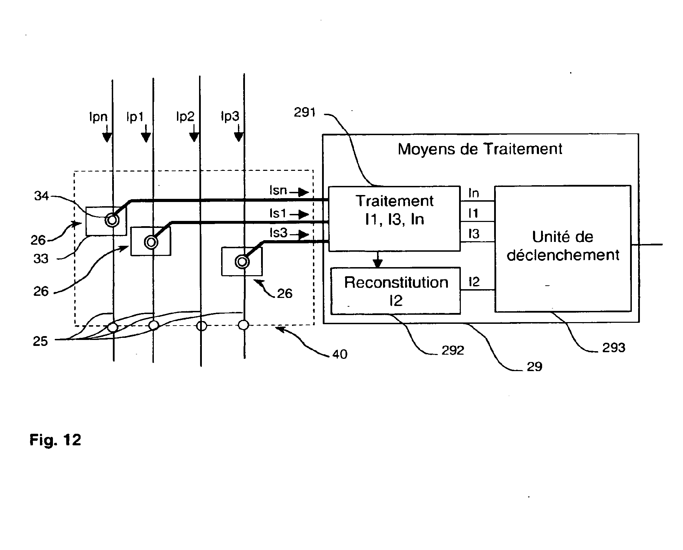

Comme représenté sur la figure 12, les signaux Isn, Is1, Is3 représentatifs des courants électriques primaires Ipn, Ip1, Ip3 sont appliqués à l'entrée du circuit de traitement 291 des moyens de traitements 29. Le circuit de traitement 291 fournit, à une unité de déclenchement 293, des signaux In, I1, I3 représentatifs des courants mesurés et traités.

Un circuit de reconstitution 292 connecté au circuit de traitement 291 et à l'unité de déclenchement 293 reçoit des signaux représentatifs des courants mesurés et traités par le circuit de traitement 291. Lorsque aucun défaut différentiel n'est observé, la somme vectorielle des courants électriques circulant dans toutes les lignes de courant est nulle. Le circuit de reconstitution 292 peut alors calculer et fournir un signal représentatif I2 de la phase reconstituée.

Ainsi, à l'unité de déclenchement 293 reçoit des signaux représentatifs des courants des trois phases circulant dans les lignes de courant à protéger.

L'unité de déclenchement 293 effectue les fonctions de déclenchement et fournit un signal de déclenchement au relais 31 lorsque des signaux de courant In, I1, I2, I3 qu'il reçoit dépassent des seuils pendant des durées prédéterminées. Les fonctions de déclenchement sont notamment, les fonctions long retard, court retard et instantané. Le relais 31 commande alors l'ouverture de contacts 30 à travers le mécanisme d'ouverture 32.

## Revendications

1. Dispositif de mesure de courant différentiel (9) destiné à la mesure de courant différentiel dans aux moins deux lignes de courant (25), comportant :
• un premier circuit magnétique (16) destiné à entourer les lignes de courant (25), formant un circuit primaire d'un transformateur,
• un premier enroulement secondaire (11) enroulé autour dudit circuit magnétique et formant le circuit secondaire du transformateur,
• un blindage métallique (10) entourant le premier enroulement secondaire (11) et le circuit magnétique (16),
**caractérisé en ce qu**'au moins un second enroulement secondaire (2) entoure au moins une partie du blindage métallique (10) constituant un second circuit magnétique d'au moins un second capteur de courant destiné à fournir un signal électrique représentatif d'un courant circulant dans au moins une ligne de courant (25).

2. Dispositif de mesure de courant différentiel selon la revendication 1 **caractérisé en ce** le blindage métallique (10) est constitué d'un blindage extérieur (14), d'un blindage intérieur (13) et d'au moins un blindage latéral (12A, 12B).

3. Dispositif de mesure de courant différentiel selon la revendication 2 **caractérisé en ce** le blindage métallique (10) comporte deux blindages latéraux (12A, 12B).

4. Dispositif de mesure de courant différentiel selon la revendication 3 **caractérisé en ce qu**'au moins un second enroulement secondaire (2) entoure au moins une partie du blindage extérieur (14), au moins une partie du blindage intérieur (13) et au moins une partie des blindages latéraux (12A, 12B), lesdits blindages entourés par ledit au moins un second enroulement secondaire (2) formant le circuit magnétique d'au moins un second capteur de courant, chaque blindage (13, 14, 12A, 12B) entourant les lignes de courant (25).

5. Dispositif de mesure de courant différentiel selon la revendication 4 **caractérisé en ce qu'**un second enroulement secondaire (2) entoure totalement le blindage métallique (10).

6. Dispositif de mesure de courant différentiel selon la revendication 3 **caractérisé en ce qu'**au moins un second enroulement secondaire (2) entoure au moins une partie d'un des blindages latéraux (12A, 12B).

7. Dispositif de mesure de courant différentiel selon la revendication 6 **caractérisé en ce qu**'au moins un second enroulement secondaire (2) entoure un des deux blindages latéraux (12A, 12B).

8. Dispositif de mesure de courant différentiel selon la revendication 6 **caractérisé en ce qu'**au moins un second enroulement secondaire (2A) entoure au moins une partie d'un premier blindage latéral (12A), et au moins un second bobinage secondaire (2B) entoure au moins une partie du second blindage latéral (12B), lesdits blindages entourés formant les circuits magnétiques d'au moins deux seconds capteurs de courant.

9. Dispositif de mesure de courant différentiel selon l'une quelconque des revendications précédentes **caractérisé en ce qu'**au moins un des blindages entouré par un second enroulement secondaire (2) comporte au moins un entrefer (60).

10. Module de déclenchement (40) destiné à se connecter à un dispositif de coupure (50) et comprenant N lignes de courant (25) **caractérisé en ce que** un dispositif de mesure de courant différentiel (9) selon les revendications précédentes est positionné autour des lignes de courant (25), le second capteur de courant du dispositif de mesure de courant différentiel (9) étant destiné à être relié à des moyens d'alimentation (28) et/ou des moyens de traitement (29) d'un dispositif de coupure (50), le premier enroulement secondaire (11) du dispositif de mesure de courant différentiel (9) étant destiné à être relié à des moyens de traitement (29) dudit dispositif de coupure.

11. Module de déclenchement selon la revendication 10 **caractérisé en ce qu'**au moins N-1 lignes de courant (25) possèdent respectivement un capteur de courant mixte (26) comportant:
• un premier bobinage (35) enroulé sur un circuit magnétique (33) et destiné à être relié aux moyens d'alimentation (28) d'un dispositif de coupure (50)
• un second bobinage (34) enroulé sur un circuit amagnétique et destiné à être relié aux moyens de traitement (29) d'un dispositif de coupure (50).

12. Dispositif de coupure (50) destiné à la protection d'au moins N lignes électriques (25), comprenant des moyens d'alimentation (28), des moyens de traitement (29), un mécanisme d'ouverture (32) de contacts électriques (30) **caractérisé en ce qu**'il comporte un module de déclenchement (40) selon les revendications 10 à 11, les moyens de traitement (29) du dispositif de coupure (50) étant connectés au dispositif de mesure de courant différentiel (9) dudit module de déclenchement.

13. Dispositif de coupure selon la revendication 12 **caractérisé en ce que** les moyens d'alimentations (28) sont reliés aux capteurs de courant mixtes (26) du module de déclenchement (40) via les premiers bobinages (35) et sont reliés à au moins un second enroulement secondaire (2) du dispositif de mesure de courant différentiel (9).

14. Dispositif de coupure selon la revendication 12 **caractérisé en ce que** les moyens de traitement (29) sont reliés aux capteurs de courant mixtes (26) du module de déclenchement (40) via les seconds bobinages (34) et sont reliés au premier enroulement secondaire (11) du dispositif de mesure de courant différentiel (9).

## Claims

1. A differential current measuring device (9) designed for measuring differential current in at least two current lines (25), comprising:
• a first magnetic circuit (16) designed to surround the current lines (25), forming a primary circuit of a transformer,
• a first secondary winding (11) wound around said circuit magnetic and forming the secondary circuit of the transformer,
• a metal shielding (10) surrounding the first secondary winding (11) and the magnetic circuit (16),
**characterized in that** at least one second secondary winding (2) surrounds at least a part of the metal shielding (10) forming a second magnetic circuit of at least one second current sensor designed to supply an electric signal representative of a current flowing in at least one current line (25).

2. The differential current measuring device according to claim 1 **characterized in that** the metal shielding (10) is made up of an outer shielding (14), an inner shielding (13) and at least one lateral shielding (12A, 12B).

3. The differential current measuring device according to claim 2 **characterized in that** the metal shielding (10) comprises two lateral shieldings (12A, 12B).

4. The differential current measuring device according to claim 3 **characterized in that** at least one second secondary winding (2) surrounds at least a part of the outer shielding (14), at least a part of the inner shielding (13) and at least a part of the lateral shieldings (12A, 12B), said shieldings surrounded by said at least one second secondary winding (2) forming the magnetic circuit of at least one second current sensor, each shielding (13, 14, 12A, 12B) surrounding the current lines (25).

5. The differential current measuring device according to claim 4 **characterized in that** a second secondary winding (2) completely surrounds the metal shielding (10).

6. The differential current measuring device according to claim 3 **characterized in that** at least one second secondary winding (2) surrounds at least a part of one of the lateral shieldings (12A, 12B).

7. The differential current measuring device according to claim 6 **characterized in that** at least one second secondary winding (2) surrounds one of the two lateral shieldings (12A, 12B).

8. The differential current measuring device according to claim 6 **characterized in that** at least one second secondary winding (2A) surrounds at least a part of a first lateral shielding (12A), and at least one second secondary winding (2B) surrounds at least a part of the second lateral shielding (12B), said surrounded shieldings forming the magnetic circuits of at least two second current sensors.

9. The differential current measuring device according to any one of the foregoing claims **characterized in that** at least one of the shieldings surrounded by a second secondary winding (2) comprises at least one air-gap (60).

10. A trip module (40) designed to be connected to a switchgear device (50) and comprising N current lines (25) **characterized in that** a differential current measuring device (9) according to the foregoing claims is placed around current lines (25), the second current sensor of the device for measuring differential current (9) being designed to be connected to power supply means (28) and/or processing means (29) of a switchgear device (50), the first secondary winding (11) of the differential current measuring device (9) being designed to be connected to processing means (29) of said switchgear device.

11. The trip module according to claim 10 **characterized in that** at least N-1 current lines (25) respectively have a mixed current sensor (26) comprising:
• a first winding (35) wound on a magnetic circuit (33) and designed to be connected to the power supply means (28) of a switchgear device (50)
• a second winding (34) wound on a non-magnetic circuit and designed to be connected to the processing means (29) of a switchgear device (50).

12. A switchgear device (50) designed for protection of at least N electric lines (25), comprising power supply means (28), processing means (29), an opening mechanism (32) for opening electric contacts (30) **characterized in that** it comprises a trip module (40) according to claims 10 to 11, the processing means (29) of the switchgear device (50) being connected to the differential current measuring device (9) of said trip module.

13. The switchgear device according to claim 12 **characterized in that** the power supply means (28) are connected to the mixed current sensors (26) of the trip module (40) via the windings (35) and are connected to at least one second secondary winding (2) of the differential current measuring device (9).

14. The switchgear device according to claim 12 **characterized in that** the processing means (29) are connected to the mixed current sensors (26) of the trip module (40) via the windings (34) and are connected to the first secondary winding (11) of the differential current measuring device (9).

## Patentansprüche

1. Differenzstrom-Messeinrichtung (9) zur Messung des Differenzstroms in mindestens zwei Stromleitungen, welche Einrichtung
• einen ersten Magnetkreis (16), der dazu dient, um die Stromleitungen (25) geführt zu werden und so einen Primärkreis eines Wandlers zu bilden,
• eine erste Sekundärwicklung (11), die um den genannten Magnetkreis geführt ist und den Sekundärkreis des Wandlers bildet,
• sowie eine, um die erste Sekundärwicklung (11) und den Magnetkreis (16) geführte Metallabschirmung (10) umfasst,
**dadurch gekennzeichnet, dass** mindestens eine zweite Sekundärwicklung (2) um mindestens einen Teil der Metallabschirmung (10) geführt ist, die einen zweiten Magnetkreis mindestens eines zweiten Stromwandlers bildet, welcher dazu dient, ein elektrisches Signal zu liefern, das einen in mindestens einer Stromleitung (25) fließenden Strom abbildet.

2. Differenzstrom-Messeinrichtung nach Anspruch 1, **dadurch gekennzeichnet, dass** die Metallabschirmung (10) aus einer äußeren Abschirmung (14), einer inneren Abschirmung (13) und mindestens einer seitlichen Abschirmung (12A, 12B) besteht.

3. Differenzstrom-Messeinrichtung nach Anspruch 2, **dadurch gekennzeichnet, dass** die Metallabschirmung (10) zwei seitliche Abschirmungen (12A, 12B) umfasst.

4. Differenzstrom-Messeinrichtung nach Anspruch 3, **dadurch gekennzeichnet, dass** mindestens eine zweite Sekundärwicklung (2) um mindestens einen Teil der äußeren Abschirmung (14), mindestens einen Teil der inneren Abschirmung (13) und mindestens einen Teil der seitlichen Abschirmungen (12A, 12B) geführt ist, wobei die genannten, von der mindestens einfach vorhandenen zweiten Sekundärwicklung (2) umgebenen Abschirmungen den Magnetkreis mindestens eines zweiten Stromwandlers bilden und jede Abschirmung (13, 14, 12A, 12B) um die Stromleitungen (25) geführt ist.

5. Differenzstrom-Messeinrichtung nach Anspruch 4, **dadurch gekennzeichnet, dass** eine zweite Sekundärwicklung (2) um die gesamte Metallabschirmung (10) geführt ist.

6. Differenzstrom-Messeinrichtung nach Anspruch 3, **dadurch gekennzeichnet, dass** mindestens eine zweite Sekundärwicklung (2) um mindestens einen Teil einer der seitliche Abschirmungen (12A, 12B) geführt ist.

7. Differenzstrom-Messeinrichtung nach Anspruch 6, **dadurch gekennzeichnet, dass** mindestens eine zweite Sekundärwicklung (2) um eine der seitlichen Abschirmungen (12A, 12B) geführt ist.

8. Differenzstrom-Messeinrichtung nach Anspruch 6, **dadurch gekennzeichnet, dass** mindestens eine zweite Sekundärwicklung (2a) um mindestens einen Teil einer ersten seitlichen Abschirmung (12A) und mindestens eine zweite Sekundärwicklung (2b) um mindestens einen Teil der zweiten seitlichen Abschirmung (12B) geführt ist, wobei die von den Wicklungen umgebenen Abschirmungen Magnetkreise von mindestens zwei zweiten Stromwandlern bilden.

9. Differenzstrom-Messeinrichtung nach irgendeinem der vorhergehenden Ansprüche, **dadurch gekennzeichnet, dass** mindestens eine der von einer zweiten Sekundärwicklung (2) umgebenen Abschirmungen mindestens einen Luftspalt (60) aufweist.

10. Auslösemodul (40), das zum Anschluss an eine Abschaltvorrichtung (50) dient und N Stromleitungen umfasst, **dadurch gekennzeichnet, dass** eine Differenzstrom-Messeinrichtung (9) nach den vorhergehenden Ansprüchen um Stromleitungen (25) geführt ist, wobei der zweite Stromwandler der Differenzstrom-Messeinrichtung (9) dazu dient, mit Stromversorgungsmitteln (28/29) und/oder Verarbeitungsmitteln (29) einer Abschaltvorrichtung (50) verbunden zu werden, und die erste Sekundärwicklung (11) der Differenzstrom-Messeinrichtung (9) dazu dient, mit den Verarbeitungsmitteln (29) der genannten Abschaltvorrichtung verbunden zu werden.

11. Auslösemodul nach Anspruch 10, **dadurch gekennzeichnet, dass** mindestens N-1 Stromleitungen (25) mit jeweils einem kombinierten Stromwandler (26) bestückt sind, der
• eine um einen Magnetkreis (33) geführte erste Wicklung (35), die dazu dient, mit Stromversorgungsmitteln (28) einer Abschaltvorrichtung (50) verbunden zu werden,
• und eine um einen unmagnetischen Träger geführte zweite Wicklung (34) umfasst, die dazu dient, mit Verarbeitungsmitteln (29) einer Abschaltvorrichtung (50) verbunden zu werden.

12. Abschaltvorrichtung (50) zum Schutz von mindestens N Stromleitungen (25) mit Stromversorgungsmitteln (28), Verarbeitungsmitteln (29) und einem Ausschaltmechanismus (32) zur Abschaltung elektrischer Kontakte (30), **dadurch gekennzeichnet, dass** sie ein Auslösemodul (40) nach einem der Ansprüche 10 bis 11 umfasst, wobei die Verarbeitungsmittel (29) der Abschaltvorrichtung (50) mit der Differenzstrom-Messeinrichtung (9) des genannten Auslösemoduls verbunden sind.

13. Abschaltvorrichtung nach Anspruch 12, **dadurch gekennzeichnet, dass** die Stromversorgungsmittel (28) über die ersten Wicklungen (35) an die kombinierten Stromwandler (26) des Auslösemoduls (40) angeschlossen sind und mit mindestens einer zweiten Sekundärwicklung (2) der Differenzstrom-Messeinrichtung (9) verbunden sind.

14. Abschaltvorrichtung nach Anspruch 12, **dadurch gekennzeichnet, dass** die Verarbeitungsmittel (29) über die zweiten Wicklungen (34) an die kombinierten Stromwandler (26) des Auslösemoduls (40) angeschlossen sind und mit der ersten Sekundärwicklung (11) der Differenzstrom-Messeinrichtung (9) verbunden sind.
